# EUROPEAN PATENT APPLICATION

(11) **EP 4 734 152 A1**
(43) Date of publication of application: **29.04.2026**
(21) Application number: 24825201.7
(22) Date of filing: 17.06.2024
(51) Int. Cl.: H01L 21/673

(54) **SUBSTRATE CARRYING MECHANISM, TRANSFER MECHANISM, AND SEMICONDUCTOR PROCESS APPARATUS**

(30) Priority: 21.06.2023 CN 202310744559
(71) Applicant: Beijing NAURA Microelectronics Equipment Co., Ltd., Beijing 100176 (CN)
(72) Inventor: SHI, Zhe, Beijing 100176 (CN); LI, Jianguo, Beijing 100176 (CN); WANG, Yang, Beijing 100176 (CN); ZHAO, Jiabin, Beijing 100176 (CN)
(74) Representative: Cohausz & Florack
(86) International application number: PCT/CN2024/099556
(87) International publication number: WO 2024/260305

(57) **Abstract**

A substrate carrier mechanism, a transfer assembly and a semiconductor processing equipment are provided. The substrate carrier mechanism comprises boats for carrying substrates, and the boats are arranged along a vertical direction. The substrate carrier mechanism disclosed herein can enhance the substrate loading capacity.

## Description

### FIELD OF THE INVENTION

The present disclosure relates to the technical field of substrate processing, and in particular, to a substrate carrier mechanism, a transfer assembly, and a semiconductor processing equipment.

### BACKGROUND OF THE INVENTION

As the photovoltaic solar cell market continues to thrive and related technologies reach maturity, manufacturers have achieved comparable technical capabilities in horizontal furnace systems and are now shifting their focus toward innovative vertical furnace configurations. Among these equipment structures, quartz boats play a critical role by carrying substrates into the processing chamber. To facilitate quartz boat as carriage, the transfer system must reliably move the quartz boat from the cassette loader into the chamber before processing, and then return it afterward to prepare for the next stage of solar cell fabrication.

However, despite their widespread use, conventional quartz boats face limitations in accommodating larger substrate loads, which has increasingly hindered scalability and efficiency in advanced photovoltaic production.

### SUMMARY OF THE INVENTION

A first embodiment of the present disclosure provides a substrate carrier mechanism.

The substrate carrier mechanism comprises boats configured to carry substrates. The boats are arranged along a vertical direction.

The substrate carrier mechanism disclosed in the present disclosure offers the following advantages.

By distributing two or more boats along the vertical direction, the height of each individual boat can be reduced while maintaining the same overall system height. This design reduces the vertical length of the substrate-supporting component within each boat, helping to prevent a loss of structural support caused by buckling due to excessive component length. In other words, using multiple vertically arranged boats under a fixed overall height improves the substrate carrier mechanism's ability to support substrates and increases its overall loading capacity.

In some examples of the present disclosure, the substrate carrier mechanism further comprises a support structure, and the support structure is configured to support at least a few of the boats along the vertical direction.

In some examples of the present disclosure, the support structure comprises a transverse support portion and side support portions.

The transverse support portion is configured to support the at least few of the boats.

The side support portions are arranged on opposite sides of the transverse support portion along a first transverse direction and configured to jointly support the transverse support portion.

In some examples of the present disclosure, the at least few of the boats supported by the transverse support portion is located in an upper section in overall arrangement of the boats.

In some examples of the present disclosure, the support structure further comprises hangers fixedly arranged on the side support portions.

Each of the boats is configured with hanging lugs matched with the hangers.

In some examples of the present disclosure, the hangers are arranged on opposite sides of each of the side support portions along a second transverse direction, to make two boats arranged side by side along the second transverse direction by suspending the hanging lugs on the hangers. The second transverse direction is perpendicular to the first transverse direction.

In some examples of the present disclosure, the hanging lugs are arranged on opposite sides of each of the boats along the first transverse direction.

The hangers arranged on the same side of two side support portions arranged opposite to each other along the first transverse direction are correspondingly distributed, to suspend the hanging lugs of one boat that are arranged opposite to each other along the first transverse direction.

In some examples of the present disclosure, each of the hanging lugs comprises a first trunnion and a second trunnion arranged in parallel and spaced apart along the second transverse direction, and the first trunnion and the second trunnion are both arranged along the first transverse direction.

A distal end of the second trunnion is farther from a geometric center of the boat than a distal end of the first trunnion. The second trunnion is configured to be suspended on the hanger, and during suspension, the second trunnion is closer to an adjacent boat arranged side by side along the second transverse direction than the first trunnion is.

In some examples of the present disclosure, the support structure further comprises a bottom plate provided with first positioning portions.

The substrate carrier mechanism further comprises a support bracket configured to support the bottom plate. The support bracket is provided with first protruding positioning portions that are matched with the first positioning portions.

In some examples of the present disclosure, the first positioning portions are the first protruding positioning portions spaced apart on a circumferential side of the bottom plate.

The first protruding positioning portions are positioning bumps protruding upward relative to support surfaces of the support bracket, and a circumferential side of each of the first protruding positioning portions is matched with a circumferential side of one of the first positioning portions.

In some examples of the present disclosure, the bottom plate is further provided with second positioning portions, and the second positioning portions are configured to match second protruding positioning portions of a transfer assembly for transporting the substrate carrier mechanism.

In some examples of the present disclosure, the second positioning portions are second protruding positioning portions spaced apart on the circumferential side of the bottom plate. A circumferential side of each of the second positioning portions faces away from the circumferential side of a corresponding one of the first positioning portions.

In some examples of the present disclosure, the substrate carrier mechanism further comprises a support bracket and a flow equalizing plate.

The support bracket comprises support rods and transverse support members, and each of the transverse support members is arranged between every two adjacent support rods.

The flow equalizing plate is supported by the transverse support members. The flow equalizing plate is provided with first positioning holes, and each of the support rods penetrates through one of the first positioning holes.

In some examples of the present disclosure, the substrate carrier mechanism further comprises a heat preservation barrel located below the flow equalizing plate. A top of the heat preservation barrel is provided with second positioning holes, and each of the support rods penetrates into one of the second positioning holes. The heat preservation barrel is filled with thermal insulation material.

In some examples of the present disclosure, each of the boats comprises limiting columns and support columns. The support columns are arranged in at least two rows along a first transverse direction, each row has at least two support columns arranged at intervals along a second transverse direction. The second transverse direction is perpendicular to the first transverse direction.

Opposing side surfaces of two adjacent rows of the support columns are respectively provided with tooth slots extending in an inclined direction inclined relative to a horizontal plane, and the tooth slots on the opposing side surfaces of two adjacent rows of the support columns are configured to support side edges of the substrates.

Each of the limiting columns is located on one side of two adjacent rows of the support columns near lower ends of the tooth slots. The limiting column and the two adjacent rows of the support columns form a space for accommodating the substrates.

In some examples of the present disclosure, each of the boats comprises an upper end plate, a lower end plate, and support columns connected between the upper end plate and the lower end plate. Each of the support columns is provided with tooth slots for supporting the substrates, and the tooth slots are arranged at intervals along the vertical direction. A first spacing between the uppermost one of the tooth slots and the upper end plate is less than or equal to 9 mm, and a second spacing between the lowermost one of the tooth slots and the lower end plate is less than or equal to 9 mm.

A second embodiment of the present disclosure provides a transfer assembly.

The transfer assembly is configured to clamp the support structure in the substrate carrier mechanism as described in any one of the examples provided in the first embodiment of the present disclosure. The support structure comprises a bottom plate, the transfer assembly comprises a bearing member, and the bearing member is configured to support the bottom plate of the support structure.

By clamping the support structure with the transfer assembly and supporting the support structure via the bearing member, movement of the substrate carrier mechanism relative to the transfer assembly during transport can be prevented, thereby enhancing the stability of substrate transfer.

In some examples of the present disclosure, the bottom plate is provided with second positioning portions.

The bearing member comprises a bearing plate, an upper surface of the bearing plate is provided with second protruding positioning portions that are matched with the second positioning portions.

In some examples of the present disclosure, the second protruding positioning portions are positioning columns arranged on the upper surface of the bearing plate, the second positioning portions are second protruding positioning portions spaced apart on a circumferential side of the bottom plate, and each of the second protruding positioning portions is matched with one of the second positioning portions.

In some examples of the present disclosure, the bearing member comprises a bearing plate.

An upper surface of the bearing plate is provided with a position sensor, to detect whether the support structure is located on the bearing plate.

In some examples of the present disclosure, the transfer assembly further comprises a clamping base and a clamping assembly mounted on the clamping base. The clamping assembly comprises a clamping power source and a clamping member.

The clamping power source is pivotally connected to the clamping base.

The clamping member is pivotally connected to the clamping base and is configured to cooperate with the bearing member to clamp the support structure. The clamping member comprises a driven portion and a pressing portion fixedly connected the driven portion, the driven portion is pivotally connected to a power output end of the clamping power source, and the pressing portion is configured to compress the support structure.

A third embodiment of the present disclosure provides a semiconductor processing equipment.

The semiconductor processing equipment comprises a process tube and the substrate carrier mechanism as described in any one of the examples provided in the first embodiment of the present disclosure. The substrate carrier mechanism is located in the process tube.

By providing the substrate carrier mechanism in the semiconductor processing equipment, correspondingly, the semiconductor processing equipment has all the advantages of the above-mentioned substrate carrier mechanism.

### BRIEF DESCRIPTION OF DRAWINGS

In order to more clearly illustrate the technical solutions in the embodiments of the present disclosure, the following is a brief description of the accompanying drawings to be used in the description of the embodiments. It is obvious that the following description of the accompanying drawings is only about embodiments of the present invention. For the person of ordinary skill in the art, other drawings can be obtained without creative work, according to these accompanying drawings.
FIG. 1 is a schematic structural diagram of a substrate carrier mechanism according to Embodiment 1 of the present disclosure.
FIG. 2 is a schematic structural diagram of a support structure in the substrate carrier mechanism according to Embodiment 1 of the present disclosure.
FIG. 3 is a schematic structural diagram of a boat in the substrate carrier mechanism according to Embodiment 1 of the present disclosure.
FIG. 4 is a schematic structural diagram of the boat shown in FIG. 3 after loading substrates.
FIG. 5 is a schematic structural diagram of a support bracket in the substrate carrier mechanism according to Embodiment 1 of the present disclosure.
FIG. 6 is a schematic structural diagram illustrating a configuration in which the support structure is positioned on a transfer assembly according to Embodiment 2 of the present disclosure.
FIG. 7 is a schematic structural diagram of the transfer assembly according to Embodiment 2 of the present disclosure.
FIG. 8 is a schematic structural diagram of a semiconductor processing equipment according to Embodiment 3 of the present disclosure.

Reference numerals
10-Boat; 20-Support structure; 30-Substrate; 40-Support bracket; 50-Flow equalizing plate; 60-Heat preservation barrel; 80-Process tube;
11-Upper end plate; 12-Lower end plate; 13-Support column; 131-Tooth slot; 14-Limiting column; 15-Lug mounting plate; 16-First trunnion; 17-Second trunnion;
21-Side support portion; 22-Reinforcing rib plate; 23-Transverse support portion; 24-Hanger; 25-Bottom plate; 251-First positioning portion; 252-Second positioning portion;
41-Support rod; 412-First protruding positioning portion; 42-Transverse support member;
71-Bearing plate; 711-Second protruding positioning portion; 72-Clamping power source; 721-Extension rod; 722-Cylinder; 73-Clamping member; 731-Transmission rod; 732-Driven portion; 733-Pressing portion; 734-Rotating shaft; 74-Clamping base; 75-Position sensor.

### DETAILED DESCRIPTION OF THE INVENTION

Related art has proposed a substrate carrier device for vertical furnaces, which includes a quartz boat having an elongated vertical three-dimensional structure. The quartz boat is relatively long and supported by guide posts to improve stability during lifting and transport. However, due to its vertically extended shape, an overly long quartz boat is prone to deformation or breakage. The guide posts, typically slender vertical rods, also suffer from low structural strength and are susceptible to fracture. These limitations restrict the substrate loading capacity of the quartz boat.

To facilitate a clearer understanding of the objectives, features, and advantages of the present disclosure, specific embodiments are described in detail below with reference to the accompanying drawings. It should be understood that the embodiments described herein are provided solely for illustrative purposes and are not intended to restrict the scope of the present disclosure.

### Embodiment 1

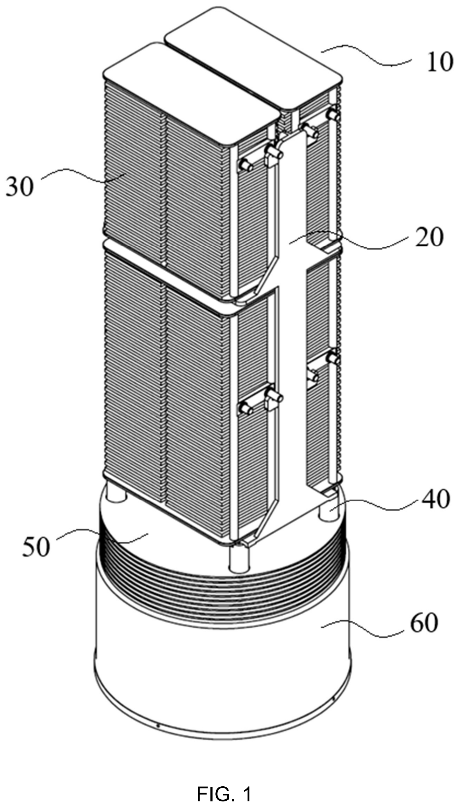

FIG. 1 is a schematic structural diagram of a substrate carrier mechanism according to Embodiment 1 of the present disclosure. As shown in FIG. 1, the substrate carrier mechanism provided in Embodiment 1 of the present disclosure comprises boats 10, which are configured to carry substrates 30.

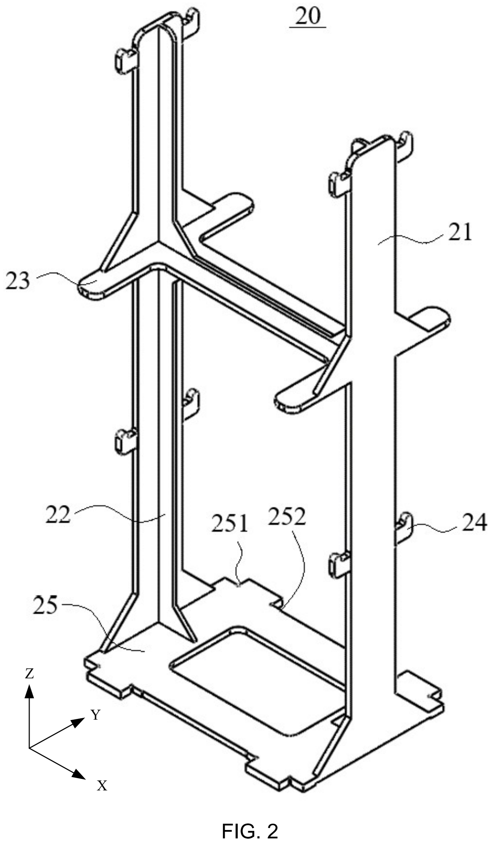

The boats 10 are arranged along a vertical direction (i.e. along a direction parallel to the Z-axis in FIG. 2).

In Embodiment 1, the boats 10 can be quartz boats, and the substrates 30 carried by the boats 10 can be silicon wafers.

By distributing two or more boats 10 along the vertical direction (also referred to as height direction), the height of each individual boat 10 can be reduced while maintaining the same overall system height. This design reduces the vertical length of the substrate-supporting component within each boat 10, helping to prevent a loss of structural support caused by buckling due to excessive component length. In other words, using multiple vertically arranged boats 10 under a fixed overall height improves the substrate carrier mechanism's ability to support substrates 30 and increases its overall loading capacity.

In addition to the implementations described above, another implementation allows the boats 10 to be directly stacked along the vertical direction. Although the lowermost boat 10 must bear the weight of the upper sections of the boats and the substrates 30 they carry, the vertical length of the substrate-supporting component each is reduced. This reduction mitigates the weakening of load-bearing capacity caused by buckling effects, thereby enhancing the overall substrate support capability of the boats 10.

FIG. 2 is a schematic structural diagram of a support structure in the substrate carrier mechanism according to Embodiment 1 of the present disclosure. As shown in FIGs. 1 and 2, preferably, the substrate carrier mechanism further comprises a support structure 20. The support structure 20 is configured to support at least few of the boats 10 along the vertical direction.

By providing the support structure 20 to support the boats 10 along the vertical direction, the longitudinal load of the boats 10 can be reduced. The support structure 20 offers significantly higher vertical load-bearing capacity compared to the boats 10, which helps enhance the overall ability to carry substrates 30.

Preferably, the support structure 20 is configured to support a few of the boats 10 located in an upper section in overall arrangement of the boats. In this configuration, the weight of the upper sections of the boats 10 and the substrates 30 carried by the upper sections of the boats 10 can be transferred to the support structure 20, such that these loads are borne by the support structure 20. As a result, the lower sections of the boats 10 are not required to support the weight of the upper sections of the boats 10 and their carried substrates 30, thereby reducing the longitudinal load of the boats 10. The support structure 20 offers significantly higher vertical load-bearing capacity compared to the boats 10, which helps enhance the overall ability to carry substrates 30. The lower sections of the boats 10 may, for example, be stacked directly along the vertical direction. Of course, in practical applications, the support structure 20 may also be used to carry the boats 10 located in the lower or middle sections. The remaining sections of the boats 10 and their carried substrates that are not supported by the support structure 20 may be directly stacked along the vertical direction. The support structure 20 may also be configured to carry all of the boats 10. Specifically, it may support sections of the boats 10 located in at least one of the upper, middle, or lower sections. The boats 10 may be arranged in multiple vertically stacked sections, which may include three, four, or more than five sections. Accordingly, the support structure 20 is designed to carry boats 10 from at least one of these vertical sections.

As shown in FIG. 2, preferably, the support structure 20 comprises a transverse support portion 23 and side support portions 21. The transverse support portion 23 is configured to support the at least few of the boats 10. At least two side support portions 21 are respectively arranged on opposite sides of the transverse support portion 23 along a first transverse direction (i.e. along a direction parallel to the X-axis in FIG. 2) and configured to jointly support the transverse support portion 23. Preferably, each opposite side of the transverse support portion 23 is provided with one or more side support portions 21.

In Embodiment 1, the substrate carrier mechanism comprises two side support portions 21 that are respectively arranged on the opposite sides of the transverse support portion 23 along the first transverse direction, and the side support portions 21 are plate-shaped. In Embodiment 1, the transverse support portion 23 is configured to support the at least few of the boats 10 located in the upper section in overall arrangement of the boats. For example, as shown in FIG. 1, two boats 10 located in the upper section along the vertical direction are supported by the transverse support portion 23. In this configuration, the transverse support portion 23 is fixedly connected between the two side support portions 21, at a position corresponding to the central or upper-central region of each side support portion 21. It can be understood that the connected position of the transverse support portion 23 on the side support portions 21 may be determined based on the bottom height of the corresponding few of the boats 10 to be supported. Specifically, the transverse support portion 23 can be configured as an I-shaped structure formed by two U-shaped components arranged back-to-back. That is, the transverse support portion 23 comprises a first support plate extending along the first transverse direction, and two second support plates extending along a second transverse direction (i.e., along a direction parallel to the Y-axis in FIG. 2). The first transverse direction is perpendicular to the second transverse direction. The two second support plates are respectively located on opposite sides of the first support plate along the first transverse direction, and are respectively connected to two ends of the first support plate along the first transverse direction. In Embodiment 1, the remaining boats 10 other than the two boats 10 above are supported by a bottom plate 25, which will be described later.

In addition, reinforcing rib plates 22 are further arranged between the transverse support portion 23 and the side support portions 21. The reinforcing rib plates 22 are respectively arranged on two opposing side surfaces of the side support portions 21 that are adjacent to each other, and are oriented perpendicular to both the side support portions 21 and the transverse support portion 23. The reinforcing rib plates 22 are used to further enhance the structural strength of the support structure 20, thereby improving its load-bearing capacity. Specifically, two reinforcing rib plates 22 are arranged above the transverse support portion 23, lower ends of the two reinforcing rib plates 22 are connected to an upper surface of the transverse support portion 23, side ends of the two reinforcing rib plates 22 away from each other are respectively connected to the two opposing side surfaces of the side support portions 21, and the lower ends of the two reinforcing rib plates 22 extend toward each other along the first transverse direction and are integrally connected. Similarly, another two reinforcing rib plates 22 are arranged below the transverse support portion 23 and above the bottom plate 25, upper ends of the two reinforcing rib plates 22 are connected to an lower surface of the transverse support portion 23, lower ends of the two reinforcing rib plates 22 are connected to an upper surface of the bottom plate 25, and side ends of the two reinforcing rib plates 22 away from each other are respectively connected to the two opposing side surfaces of the side support portions 21.

By arranging the two side support portions 21 on the opposite sides of the transverse support portion 23, the support area of the support structure 20 can be expanded, thereby enhancing its structural stability. Furthermore, supporting the boats 10 with the transverse support portion 23 improves overall stability. Compared to a configuration in which the boats 10 are simply stacked, the boats 10 located in the upper section are less likely to tip over or spill.

As shown in FIG. 2, preferably, the support structure 20 further comprises hangers 24 fixedly connected to the side support portions 21. Each of the boats 10 is provided with hanging lugs that are suspended on the hangers.

Specifically, in Embodiment 1, the support structure 20 supports both the upper and lower sections of the boats 10, and the boats 10 in these sections can be suspended on the hangers 24 by the hanging lugs. It should be noted that, although the boats 10 are hung on the hangers 24 through the hanging lugs, the weight of the boats 10 is mainly borne by the transverse support portion 23 and the bottom plate 25, and is not mainly borne by the hangers 24 and the hanging lugs. It will be understood by those skilled in the art that the hanging lugs are arranged on the boats 10 at positions above lower surfaces of the boats 10.

In some examples, at least two hangers 24 are respectively disposed on opposite sides of each side support portion 21 along the second transverse direction, so as to suspend two boats 10. As a result, the two boats 10 are arranged side by side along the second transverse direction and positioned at the same height level. That is to say, as shown in FIG. 2, each side support portion 21 is provided with hangers 24 on both opposite sides along the second transverse direction, thereby enabling the boats 10 to be arranged side by side in a back-to-back configuration along the second transverse direction.

Each of the boats 10 is provided with support columns 13, which will be described later. On the outer surfaces (i.e., surfaces facing away from an interior of boat 10) on both opposite sides of each of the boats 10 along the first transverse direction, a row of support columns 13 is respectively arranged. The support columns 13 in each row are interconnected via a lug mounting plate 15, which is fixedly secured to the support columns 13. The hanging lug are securely mounted on the lug mounting plate 15.

By providing hangers 24 on the side support portions 21 and hanging lugs on the boats 10, the engagement between the hangers 24 and the hanging lugs serves to laterally restrain the boats 10. This configuration helps prevent the boats 10 from falling off the support structure 20 due to shaking that may occur while the support structure 20 is transporting the boats 10, thereby enhancing their transportation stability.

In Embodiment 1, the shape of the boats 10 is rectangular when viewed from a top-down perspective. The side-by-side arrangement of the boats 10 refers to positioning the boats 10 at the same height level, with their longitudinal directions aligned in parallel. The back-to-back side-by-side arrangement of the boats 10 along the second transverse direction refers to a configuration in which the side-by-side boats 10 are positioned with their respective sides, which are provided with limiting columns 14, facing toward one another.

Specifically, in Embodiment 1, the opposite sides of each side support portion 21 along the second transverse direction do not refer to the two surfaces of the plate in its thickness direction, as the side support portion 21 is a plate-like component; instead, they refer to the two lateral edges of the side support portion 21 along the second transverse direction, which are the two vertical edges facing away from each other. The hangers 24 are respectively provided on these vertical edges.

By providing hangers 24 on the opposite sides of the support structure 20 along the second transverse direction, the boats 10 can be arranged side by side, meaning that two generally rectangular boats 10 are positioned with their longitudinal directions aligned in parallel. As a result, the overall shape of the two boats 10 in the same layer may be approximately square or a rectangle close to square. This configuration allows for an increased number of substrates 30 to be carried without significantly enlarging the inner diameter of the circular chamber, thereby helping to control the manufacturing cost of the equipment.

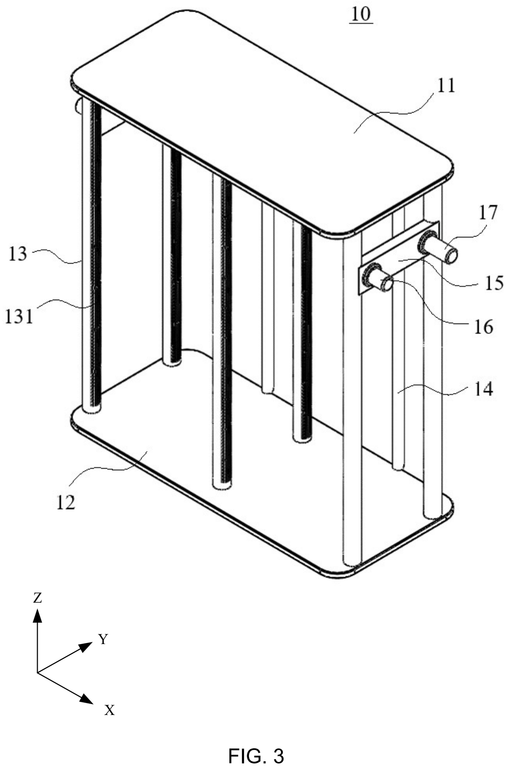

FIG. 3 is a schematic structural diagram of one boat 10 in the substrate carrier mechanism according to Embodiment 1 of the present disclosure. As shown in FIGs. 1 and 3, preferably, the hanging lugs are arranged on both opposite sides of the boat 10 along the first transverse direction. The hangers 24, which are arranged on the same side of two side support portions 21 positioned opposite to each other along the first transverse direction, are correspondingly aligned at matching height positions. This configuration allows the hanging lugs on both opposite sides of the boat 10 to be respectively suspended on the corresponding hangers 24. That is to say, the hangers 24 positioned at the same height on the two side support portions 21 are respectively used to suspend the two hanging lugs on opposite sides of the same boat 10. This provides lateral restraint at both ends of the boat 10 along the first transverse direction, thereby further preventing the boat-carrying support structure 20 from shaking the boats 10 when it moves.

Further, in some examples, each of the hanging lugs comprises a first trunnion 16 and a second trunnion 17 arranged in parallel and spaced apart along the second transverse direction, and the first trunnion 16 and the second trunnion 17 are both arranged to extend along the first transverse direction. When either the first trunnion 16 or the second trunnion 17 is suspended on the hanger 24, the respective trunnion extends outward in a direction perpendicular to the side support portion 21. In some examples, with the second trunnion 17 suspending on the hanger 24, a distal end (i.e. free end) of the second trunnion 17 is farther from a geometric center of the boat 10 than a distal end of the first trunnion 16. During suspension, the second trunnion 17 is closer to the adjacent boat 10 arranged side by side along the second transverse direction than the first trunnion is.

In other examples, each hanging lug may include additional structural features beyond the trunnions. For example, a solid portion may be provided at the free end of the trunnion, which curves downward, horizontally, or obliquely upward to form a hook-like structure, or a flange plate may be provided at the free end. These features serve to restrict movement of the hanging lug relative to the hanger 24 along the longitudinal direction of the trunnion. Any such structural additions may be adopted, provided they do not interfere with the placement of the boat 10 on the support structure 20 or with the handling and transport of the boat 10 by other components.

There are various ways to implement the configuration in which the distal end of the second trunnion 17 is positioned farther from the geometric center of the boat 10. For example, the first trunnion 16 may be shorter than the second trunnion 17. For the second trunnions 17 and the first trunnions 16 located on the same side of two boats 10 along the first transverse direction, the two second trunnions 17 are arranged between the two first trunnions 16. In other words, when two boats 10 are arranged side by side in the same layer, the spacing between the two second trunnions 17 is smaller than the spacing between the two first trunnions 16.

By designing the first trunnion 16 to be shorter than the second trunnion 17, the size of the outermost hanging lugs of boats 10 in the same layer can be reduced. This helps minimize the overall external dimensions of the substrate carrier mechanism, resulting in a cross-sectional profile that is closer to a circular shape. Consequently, the inner diameter of the circular chamber can be reduced, thereby lowering the manufacturing cost of the equipment.

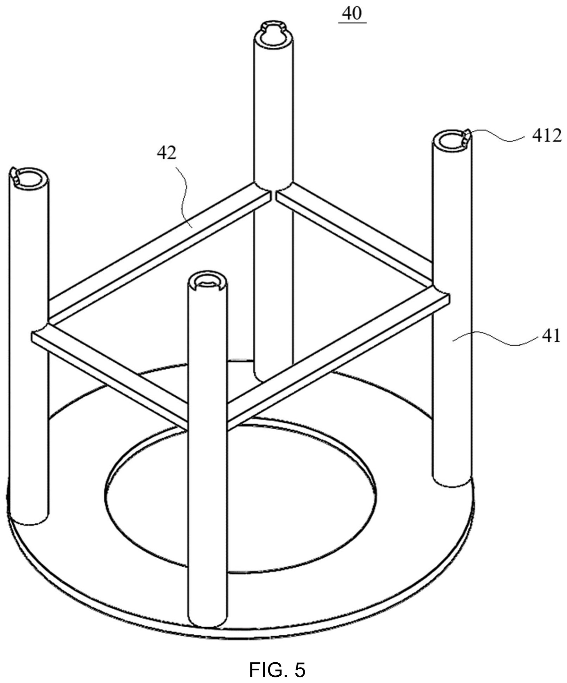

FIG. 5 is a schematic structural diagram of a support bracket in the substrate carrier mechanism according to Embodiment 1 of the present disclosure. As shown in FIGs. 2 and 5, preferably, the bottom plate 25 of the support structure 20 is provided with first positioning portions 251.

The substrate carrier mechanism further comprises a support bracket 40 configured to support the bottom plate 25. The support bracket 40 is provided with first protruding positioning portions 412 that are matched with the first positioning portions 251.

In Embodiment 1, the bottom plate 25 may have a generally #-shaped configuration and is configured to support the lower sections of the boats 10, specifically those positioned beneath the transverse support portion 23. The bottom plate 25 is fixedly connected to the lower ends of the two side support portions 21 and functions to restrict displacement of the side support portions 21.

By providing first protruding positioning portions 412 on the support bracket 40 that engage with first positioning portions 251 on the bottom plate 25, the support bracket 40 can position the support structure 20 that includes the bottom plate 25. This engagement prevents lateral movement at the bottom of the support structure 20 and enhances its overall stability.

As shown in FIGs. 2 and 5, preferably, the first positioning portions 251 are first positioning notches spaced apart on a circumferential side of the bottom plate 25. The first protruding positioning portions 412 are positioning bumps protruding upward relative to support surfaces of the support bracket 40, and a circumferential side of each of the first protruding positioning portions 412 is matched with a circumferential side of one of the first positioning portions 251.

Specifically, the first positioning portions 251 are formed at four locations on the #-shaped bottom plate 25, positioned at the intersections of the horizontal and vertical segments and offset from the center of the #-shaped structure. More specifically, the angle between the two side walls of each first positioning portion is 90°. The support bracket 40 comprises support rods 41, for example, FIG. 5 illustrates four support rods 41, each corresponding to one of the four first positioning portions. Each support rod 41 may be tubular, and the top end of each support rod 41 comprises a protruding portion formed by a 90° arc segment of the tube wall, protruding relative to the remaining 270° arc segment at the top end. This protruding portion forms the first protruding positioning portion 412. Additionally, the two side surfaces of each first protruding positioning portion 412 may be tapered, with a smaller width at the top and a larger width at the bottom, or may have locally chamfered surfaces with such a taper. This facilitates vertical engagement between the first positioning portion 251 and the first protruding positioning portion 412, enabling precise positioning.

The circumferential side of each first positioning portion 251 that engages with the corresponding first protruding positioning portion 412 may be oriented such that its opening faces away from the center of the bottom plate 25. During assembly, the support structure 20 can be horizontally shifted relative to the support bracket 40, allowing one of the first positioning portions 251 to engage with its corresponding first protruding positioning portion 412. Subsequently, the remaining three first positioning portions 251 can be aligned with the other three first protruding positioning portions 412, thereby enhancing assembly efficiency.

In another implementation, the first positioning portions 251 may also be hole-shaped, such as quarter-circle sector holes, that engage with the first protruding positioning portions 412 at the top ends of the support rods 41 to achieve positioning.

As shown in FIG. 2, preferably, the bottom plate 25 is further provided with second positioning portions 252, and the second positioning portions 252 are configured to match second protruding positioning portions 711 of a transfer assembly for transporting the substrate carrier mechanism.

Specifically, in Embodiment 1, the second positioning portions 252 are arranged on the bottom plate 25 of the support structure 20.

By providing second protruding positioning portions 711 on the transfer assembly that engage with second positioning portions 252 on the bottom plate 25, the transfer assembly can position the support structure 20 that includes the bottom plate 25. This engagement prevents lateral movement at the bottom of the support structure 20 relative to the transfer assembly and enhances its overall stability.

As shown in FIG. 2, preferably, the second positioning portions 252 are second positioning notches spaced apart on the circumferential side of the bottom plate 25. A circumferential side of each of the second positioning portions engages with a circumferential side of one of the second protruding positioning portions 711, and faces away from the circumferential side of a corresponding one of the first positioning portions. Specifically, when the circumferential side of the first positioning portion that engages with the first protruding positioning portion 412 is configured such that its opening faces away from the center of the bottom plate 25, the circumferential side of the second positioning portion that engages with the second protruding positioning portion 711 is configured such that its opening faces toward the outer edge of the bottom plate 25.

Specifically, in Embodiment 1, the bottom plate 25 has a #-shaped configuration. The second positioning portions are disposed at the intersections of the two horizontal segments and the two vertical segments of the #-shaped structure, and are located in the regions oriented toward the outer edges of the bottom plate 25. That is, at each intersection of the horizontal and vertical segments of the #-shaped bottom plate 25, there are two protruding portions facing the same outer edge: one functions as the first positioning portion, and the other as the second positioning portion. More specifically, the angle between the two side walls of each second positioning portion is 90°.

With this configuration, during assembly, the support structure 20 can be moved relative to a bearing plate 71 along a direction opposite to the opening direction of one of the second positioning portions. Once one second positioning portion is engaged with the corresponding second protruding positioning portion 711, the remaining three second positioning portions can then be aligned with the corresponding first protruding positioning portions 412, thereby improving assembly efficiency. Additionally, this arrangement makes full use of the shape of the bottom plate 25 of the support structure 20 and avoids interference with the configuration of the first positioning portions.

As shown in FIG. 5, preferably, in an implementation where the substrate carrier mechanism comprises the support bracket 40, the substrate carrier mechanism further comprises a flow equalizing plate 50, the support bracket 40 comprises support rods 41 and transverse support members 42, and each of the transverse support members 42 is arranged between every two adjacent support rods 41. For example, each transverse support member 42 is fixedly connected between the middle portions of two adjacent support rods 41.

The flow equalizing plate 50 is supported by the transverse support members 42. The flow equalizing plate 50 is provided with first positioning holes, and each of the support rods 41 penetrates through one of the first positioning holes.

Specifically, in Embodiment 1, the support bracket 40 comprises four support rods 41, and the four support rods 41 are distributed in a rectangular shape. The four support rods 41 may be configured to support the support structure 20 along the vertical direction. Each of the transverse support members 42 is fixedly connected between the middle portions of two adjacent support rods 41, and the transverse support members 42 are located on the same horizontal plane. Specifically, the flow equalizing plate 50 may be provided with four first positioning holes, and the distribution of the four first positioning holes matches the distribution of the four support rods 41, for example, the four support rods 41 are distributed in a rectangular shape, and then the four first positioning holes are distributed on the flow equalizing plate 50 in a rectangular shape of the same size.

By providing the transverse support members 42 fixedly connected between two adjacent support rods 41, the flow equalizing plate 50 can be supported so as to improve the flow field at the bottom of the substrate carrier mechanism by using the flow equalizing plate 50, so that the gas flow in the furnace chamber is more uniform, and the consistency of the processing of different substrates 30 in the process is improved.

As shown in FIG. 1, preferably, the substrate carrier mechanism further comprises a heat preservation barrel 60. The heat preservation barrel 60 is located below the flow equalizing plate 50, and second positioning holes are provided on the top of the heat preservation barrel 60. Each of the support rods 41 penetrates into one of the second positioning holes. The heat preservation barrel is filled with thermal insulation material.

Specifically, the thermal insulation material filled inside the heat preservation barrel 60 is a high-temperature-resistant ceramic fiber blanket. In Embodiment 1, the heat preservation barrel is of an inverted barrel shape, the second positioning holes are arranged at a region close to the edge of the top cover of the heat preservation barrel 60, and the distribution of the second positioning holes matches the distribution of the support rods 41. The top cover of the heat preservation barrel 60 may be directly supported by the transverse support members 42, and the flow equalizing plate 50 may be placed on the top cover of the heat preservation barrel 60, so that the flow equalizing plate 50 is also supported by the transverse support members 42.

By incorporating the heat preservation barrel 60 into the substrate carrier mechanism and filling the heat preservation barrel 60 with thermal insulation material, the thermal insulation performance at the opening located at the bottom of the chamber during processing is significantly improved compared to a configuration that comprises only the flow equalizing plate 50.

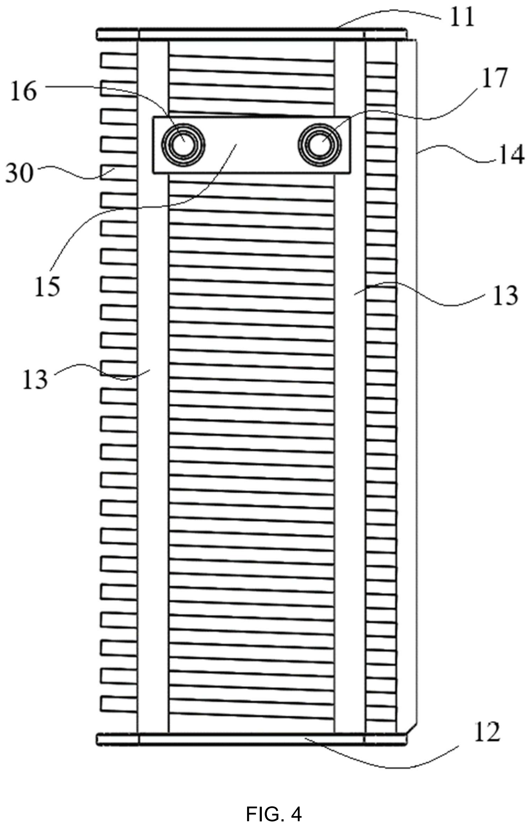

FIG. 4 is a schematic structural diagram of the boat 10 in Embodiment 1 after loading substrates 30. As shown in FIG.s 3 and 4, preferably, the boat 10 comprises limiting columns 14 and support columns 13. The support columns 13 are arranged in at least two rows along the first transverse direction, each row has at least two support columns 13 arranged at intervals along the second transverse direction. Opposing side surfaces of two adjacent rows of the support columns 13 are respectively provided with tooth slots 131 extending in an inclined direction inclined relative to the horizontal plane, and the tooth slots 131 on the opposing side surfaces of two adjacent rows of the support columns are configured to support side edges of the substrates. Since the tooth slots 131 are inclined, the substrates 30 supported by the tooth slots 131 are arranged at an angle relative to the horizontal plane. The limiting columns 14 are positioned on one side of the two adjacent rows of support columns 13, near the lower end of the two ends of the tooth slots 131, that is, on the right side of the substrates 30 supported by the tooth slots 131 as shown in FIG. 4. The limiting column 14, together with the two adjacent rows of support columns 13, defines a space for accommodating the substrates 30.

Specifically, in Embodiment 1, each of the boats 10 may be provided with six support columns 13, arranged in three rows with two support columns 13 per row. The six support columns 13 are distributed in a pattern resembling a rectangular structure with a horizontal partition extending across its central region. Along the first transverse direction, the two rows of support columns 13 located at both ends of the boat 10 are each provided with tooth slots 131 only on the side facing inward toward the interior of the boat 10. In contrast, the single row of support columns 13 located at the center of the boat 10 is provided with tooth slots 131 on both opposite side surfaces, respectively corresponding to and cooperating with the tooth slots 131 of the two end rows of support columns 13. Two stacked substrates 30 may be placed on each boat 10, with each stack supported by the tooth slots 131 of four support columns 13.

By providing tooth slots 131 that extend in an inclined direction on the support columns 13, the substrates 30, once placed in the tooth slots 131, tend to slide along a specific direction while the likelihood of sliding in the opposite direction is significantly reduced. The limiting column 14 is arranged in the corresponding direction to support the substrates 30 and block its movement, thereby significantly reducing the risk of the substrates 30 slipping in an undesired direction when placed in the boat 10, and improving the reliability of substrate transport.

As shown in FIG. 4, preferably, each of the boats 10 comprises an upper end plate 11, a lower end plate 12, and the support columns 13 connected between the upper end plate 11 and the lower end plate 12. Each of the support columns 13 is provided with tooth slots 131 for supporting the substrates 30, and the tooth slots 131 are arranged at intervals along the vertical direction. A first spacing between the uppermost one of the tooth slots 131 and the upper end plate is less than or equal to 9 mm, and a second spacing between the lowermost one of the tooth slots 131 and the lower end plate 12 is less than or equal to 9 mm.

After dividing the substrate carrier mechanism into at least two sections of boats 10 along the vertical direction, airflow irregularities may occur in the intermediate gap between adjacent sections of boats 10. When the spacing of this intermediate gap exceeds 19 mm, the processing uniformity of substrates 30 on both sides of the gap differs by more than 10%. When the spacing reaches 29 mm, the uniformity difference exceeds 15%. However, the upper end plate 11 and lower end plate 12 of each boat 10 serve to equalize airflow. By respectively reducing the spacing between the substrates 30 and the upper end plate 11, and between the substrates 30 and the lower end plate 12, the airflow at the gap location can be restored to a uniform state. When the first spacing between the substrates 30 and the upper end plate 11, as well as the second spacing between the substrates 30 and the lower end plate 12, are each less than 9 mm, the processing uniformity deviation at the gap location can be reduced to within 6%. This deviation is close to the 5% observed when the substrates 30 are continuously arranged, and thus meets the process requirements. Further reducing the spacing yields minimal improvement in uniformity, but significantly increases the difficulty of welding the tooth slots 131 on the support columns 13. Therefore, it is preferable to set the first and second spacing at 9 mm or less.

### Embodiment 2

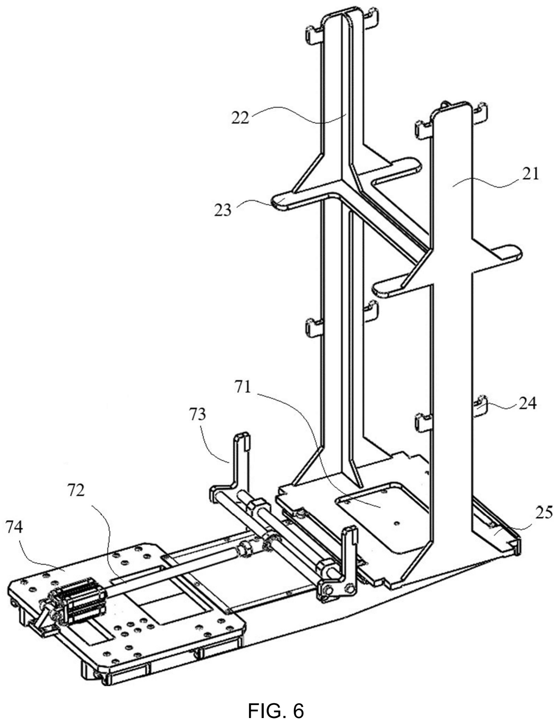

FIG. 6 is a schematic structural diagram illustrating a configuration in which the support structure in Embodiment 1 is positioned on a transfer assembly according to Embodiment 2 of the present disclosure. As shown in FIG. 6, the transfer assembly in Embodiment 2 is configured to clamp the support structure 20 in the substrate carrier mechanism as described in Embodiment 1. The support structure 20 comprises a bottom plate 25, the transfer assembly comprises a bearing member, and the bearing member is configured to support the bottom plate 25 of the support structure 20.

By clamping the support structure 20 with the transfer assembly and supporting the support structure 20 via the bearing member, movement of the substrate carrier mechanism relative to the transfer assembly during transport can be prevented, thereby enhancing the stability of substrate transfer.

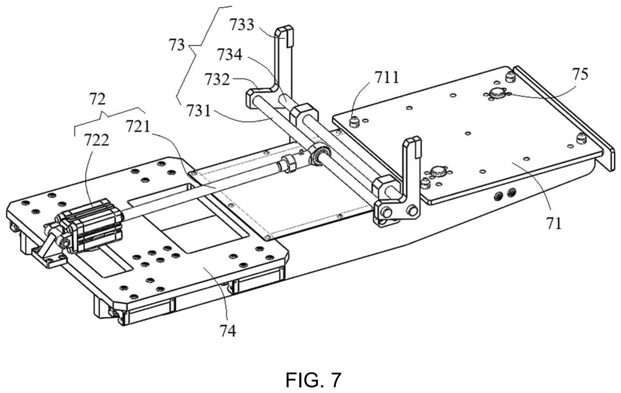

FIG. 7 is a schematic structural diagram of the transfer assembly according to Embodiment 2 of the present disclosure. As shown in FIGs. 6 and 7, preferably, the bearing member comprises a bearing plate 71, an upper surface of the bearing plate 71 is provided with second protruding positioning portions 711 that are matched with the second positioning portions 252.

By providing second protruding positioning portions 711 on the transfer assembly that engage with the second positioning portions 252 on the bottom plate 25, the transfer assembly can position the support structure 20 that includes the bottom plate 25. This engagement prevents lateral movement at the bottom of the support structure 20 relative to the bearing plate 71 and enhances its overall stability.

As shown in FIGs. 6 and 7, preferably, the second protruding positioning portions 711 are positioning columns arranged on the upper surface of the bearing plate 71, the second positioning portions 252 are second positioning notches spaced apart on the circumferential side of the bottom plate, and each of the second protruding positioning portions is matched with one of the second positioning portions.

Specifically, in Embodiment 2, the second protruding positioning portions 711 may be cylindrical in shape. The four cylindrical second protruding positioning portions 711 are respectively matched with the four second positioning portions 252, enabling horizontal positioning between the bottom plate 25 and the bearing plate 71. This configuration prevents translational and rotational movement of the bearing plate 71 relative to the bottom plate 25 within the horizontal plane.

With this configuration, during assembly, the support structure 20 can be moved relative to the bearing plate 71 along a direction opposite to the opening direction of one of the second positioning portions. Once one second positioning portion is engaged with the corresponding second protruding positioning portion 711, the remaining three second positioning portions can then be aligned with the corresponding first protruding positioning portions 412, thereby improving assembly efficiency. Additionally, this arrangement makes full use of the shape of the bottom plate 25 of the support structure 20 and avoids interference with the configuration of the first positioning portions.

As shown in FIG.s 6 and 7, preferably the bearing member comprises the bearing plate 71, the upper surface of the bearing plate 71 is provided with a position sensor 75, to detect whether the support structure 20 is located on the bearing plate 71.

Specifically, the position sensor 75 is mounted in a region in the upper surface of the bearing plate 71 corresponding to the position of the bottom plate 25 of the support structure 20, such that the position sensor 75 may detect the support structure 20 when the support structure 20 is located on the bearing plate 71.

By configuring the position sensor 75 to detect whether the support structure 20 is located on the bearing plate 71, the substrate carrier mechanism and the transfer assembly can be moved together only after confirming that the bearing plate 71 has been detected, thereby avoiding operational errors.

In another implementation, the bearing member may be non-plate-shaped. For example, multiple rods may be arranged in the same plane to form a rectangular frame, with additional rods arranged either parallel or intersecting within the frame, which can also serve a bearing function.

As shown in FIGs. 6 and 7, preferably, the transfer assembly further comprises a clamping base 74 and a clamping assembly mounted on the clamping base 74. The clamping assembly comprises a clamping power source 72 and a clamping member 73. The clamping power source 72 is pivotally connected to the clamping base 74. The clamping member 73 is pivotally connected to the clamping base 74 and is configured to cooperate with the bearing member to clamp the support structure 20. The clamping member 73 comprises a driven portion 732 and a pressing portion 733 fixedly connected the driven portion 732, the driven portion 732 is pivotally connected to a power output end of the clamping power source 72, and the pressing portion 733 is configured to compress the support structure 20.

Specifically, the clamping base 74 is fixedly connected to the bearing plate 71. In Embodiment 2, the clamping power source 72 may be implemented as a cylinder 722, with the cylinder 722 serving as the clamping power source 72. Of course, in other implementations, alternatives such as an electric push rod may also be used as the clamping power source 72. The rear end of the cylinder 722 is pivotally connected to the clamping base 74, and the piston rod of the cylinder 722 may be connected to an extension rod 721. One end of the extension rod 721 serves as the power output end of the clamping power source 72 and is pivotally connected to the clamping member 73. The clamping member 73 comprises two L-shaped plates arranged in parallel. These two L-shaped plates are pivotally connected to the clamping base 74 via a rotating shaft 734. Free ends of first arms of the two L-shaped plates are connected by a transmission rod 731, which serves as the driven portion 732 and is pivotally connected to the piston rod of the cylinder 722. Second arms of the two L-shaped plates serve as the pressing portion 733, which cooperates with the bearing plate 71 to clamp the bottom plate 25 of the support structure 20. The use of two L-shaped plates helps reduce the weight of the clamping member 73, thereby lowering the overall weight of the transfer assembly and reducing the load on the device responsible for transporting the transfer assembly and the substrate carrier mechanism.

By pivotally connecting the clamping power source 72 to the clamping base 74, and also pivotally connecting the clamping member 73 to the same clamping base 74, the clamping power source 72 can be kept outside the movement area where the substrate carrier mechanism is placed on the bearing plate 71, thus preventing the clamping power source 72 from interfering with the movement of the bearing plate 71. Moreover, by pivotally connecting the clamping member 73 to the clamping base 74, the clamping member 73 can function as a lever to amplify the force exerted by the clamping power source 72, thereby achieving a greater clamping force and improving the clamping stability of the support structure 20, preventing it from shaking or tipping during movement.

Of course, in other implementations, the clamping member 73 may adopt alternative configurations. For example, a single bent plate may be used, with the bent portion pivotally connected to the clamping base 74 and one side edge pivotally connected to the power output end of the clamping power source 72. Alternatively, the L-shaped plates may be replaced with triangular plates.

### Embodiment 3

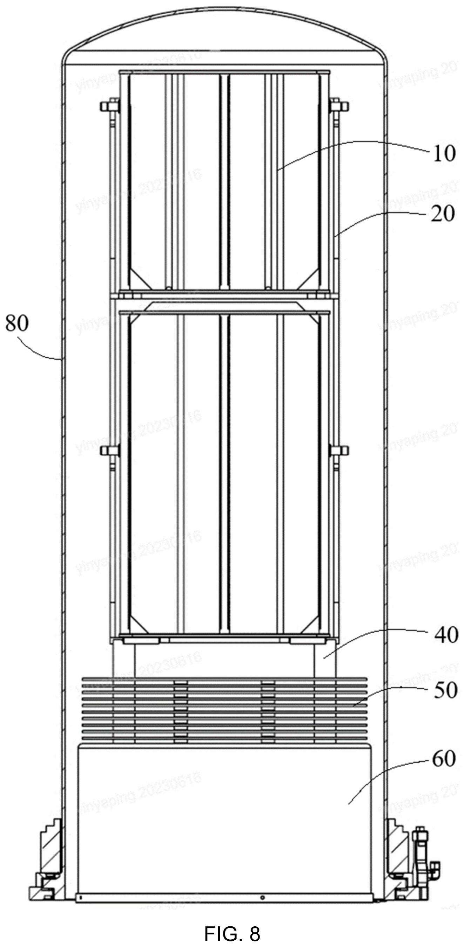

FIG. 8 is a schematic structural diagram of a semiconductor processing equipment according to Embodiment 3 of the present disclosure. As shown in FIG. 8, the semiconductor processing equipment comprises a process tube 80 and the substrate carrier mechanism in Embodiment 1. The substrate carrier mechanism is located in the process tube 80.

The substrate carrier mechanism mainly comprises boats 10, a support structure 20, a support bracket 40, a flow equalizing plate 50, and a heat preservation barrel 60. The connection relationship and action principle of the foregoing components have been described in detail in Embodiment 1, and details are not described herein again.

By providing the substrate carrier mechanism in the semiconductor processing equipment, correspondingly, the semiconductor processing equipment has all the advantages of the above-mentioned substrate carrier mechanism.

Although the present disclosure has been described in detail above, it is not limited thereto. Various modifications and alterations may be made by those skilled in the art without departing from the spirit and scope of the present disclosure. Accordingly, the scope of the present disclosure shall be defined by the appended claims.

It should also be noted that relational terms such as "first" and "second" are used solely to distinguish one element or operation from another and do not necessarily imply any actual relationship or order between such elements or operations. Furthermore, the term "comprise," and any variations thereof, are intended to denote non-exclusive inclusion. That is, a process, method, article, or apparatus that comprises a set of elements is not limited to only those elements, but may also include other elements not explicitly listed, or elements inherent to such process, method, article, or apparatus. Unless otherwise specified, an element defined by the phrase "comprises a..." does not exclude the presence of additional identical elements in the process, method, article, or apparatus that comprises the element.

Positional terms such as "upper" and "lower" used in the above embodiments are based on the orientation shown in the accompanying drawings.

The foregoing description of the disclosed embodiments enables those skilled in the art to implement or utilize the present disclosure. Various modifications to these embodiments will be readily apparent to those skilled in the art, and the general principles defined herein may be applied to other embodiments without departing from the spirit or scope of the present disclosure.

Therefore, the present disclosure shall not be limited to the embodiments disclosed herein, but shall encompass the broadest scope consistent with the principles and novel features disclosed.

## Claims

1. A substrate carrier mechanism, comprising:
boats, configured to carry substrates, wherein the boats are arranged along a vertical direction.

2. The substrate carrier mechanism according to claim 1, further comprising:
a support structure, configured to support at least a few of the boats along the vertical direction.

3. The substrate carrier mechanism according to claim 2, wherein the support structure comprises:
a transverse support portion, configured to support the at least few of the boats; and
side support portions, arranged on opposite sides of the transverse support portion along a first transverse direction and configured to jointly support the transverse support portion.

4. The substrate carrier mechanism according to claim 3, wherein the at least few of the boats supported by the transverse support portion is located in an upper section in overall arrangement of the boats.

5. The substrate carrier mechanism according to claim 3, wherein the support structure further comprises hangers fixedly arranged on the side support portions, and each of the boats is configured with hanging lugs matched with the hangers.

6. The substrate carrier mechanism according to claim 5, wherein the hangers are arranged on opposite sides of each of the side support portions along a second transverse direction, to make two of the boats arranged side by side along the second transverse direction by suspending the hanging lugs on the hangers, wherein the second transverse direction is perpendicular to the first transverse direction.

7. The substrate carrier mechanism according to claim 6, wherein the hanging lugs are arranged on opposite sides of each of the boats along the first transverse direction, wherein
the hangers arranged on the same side of two side support portions arranged opposite to each other along the first transverse direction are correspondingly distributed, to suspend the hanging lugs of one boat that are arranged opposite to each other along the first transverse direction.

8. The substrate carrier mechanism according to claim 7, wherein each of the hanging lugs comprises a first trunnion and a second trunnion, which are arranged in parallel along the first transverse direction and spaced apart along the second transverse direction; and wherein a distal end of the second trunnion is farther from a geometric center of the boat than a distal end of the first trunnion, wherein the second trunnion is configured to be suspended on the hanger, and wherein during suspension, the second trunnion is closer, than the first trunnion is, to an adjacent boat arranged side by side along the second transverse direction.

9. The substrate carrier mechanism according to any one of claims 2 to 8, wherein the support structure further comprises a bottom plate provided with first positioning portions;
wherein the substrate carrier mechanism further comprises a support bracket configured to support the bottom plate, wherein the support bracket is provided with first protruding positioning portions that are matched with the first positioning portions.

10. The substrate carrier mechanism according to claim 9, wherein the first positioning portions are first positioning notches spaced apart on a circumferential side of the bottom plate, wherein
the first protruding positioning portions are positioning bumps protruding upward relative to support surfaces of the support bracket, and a circumferential side of each of the first protruding positioning portions is matched with a circumferential side of one of the first positioning portions.

11. The substrate carrier mechanism according to claim 9, wherein the bottom plate is further provided with second positioning portions, wherein the second positioning portions are configured to match second protruding positioning portions of a transfer assembly for transporting the substrate carrier mechanism.

12. The substrate carrier mechanism according to claim 11, wherein the second positioning portions are second positioning notches spaced apart on the circumferential side of the bottom plate, wherein a circumferential side of each of the second positioning portions matches one of the second protruding positioning portions and faces away from a circumferential side of a corresponding one of the first positioning portions matching the first protruding positioning portions.

13. The substrate carrier mechanism according to any one of claims 2 to 8, further comprising a support bracket and a flow equalizing plate,
wherein the support bracket comprises support rods and transverse support members, and each of the transverse support members is arranged between every two adjacent support rods; and
wherein the flow equalizing plate is supported by the transverse support members, wherein the flow equalizing plate is provided with first positioning holes, and each of the support rods penetrates through one of the first positioning holes.

14. The substrate carrier mechanism according to claim 13, wherein the substrate carrier mechanism further comprises a heat preservation barrel located below the flow equalizing plate,
wherein a top of the heat preservation barrel is provided with second positioning holes, and each of the support rods penetrates into one of the second positioning holes, and wherein the heat preservation barrel is filled with thermal insulation material.

15. The substrate carrier mechanism according to any one of claims 1 to 8, wherein each of the boats comprises limiting columns and support columns, wherein the support columns are arranged in at least two rows along a first transverse direction, wherein each of the two rows has at least two support columns arranged at intervals along a second transverse direction, wherein the second transverse direction is perpendicular to the first transverse direction in a horizontal plane;
wherein opposing side surfaces of two adjacent rows of the support columns are respectively provided with tooth slots extending in an inclined direction slanted relative to the horizontal plane, and the tooth slots on the opposing side surfaces of two adjacent rows of the support columns are configured to support side edges of the substrates; and
wherein each of the limiting columns is located on one side of two adjacent rows of the support columns near lower ends of the tooth slots, wherein the limiting column and the two adjacent rows of the support columns form a space for accommodating the substrates.

16. The substrate carrier mechanism according to any one of claims 1 to 8, wherein each of the boats comprises an upper end plate, a lower end plate, and support columns connecting between the upper end plate and the lower end plate, wherein each of the support columns is provided with tooth slots for supporting the substrates, wherein the tooth slots are arranged at intervals along the vertical direction, wherein a first spacing between an uppermost one of the tooth slots and the upper end plate is less than or equal to 9 mm, and a second spacing between the lowermost one of the tooth slots and the lower end plate is less than or equal to 9 mm.

17. A transfer assembly, configured to clamp the support structure in the substrate carrier mechanism according to any one of claims 2 to 16, wherein the support structure comprises a bottom plate, the transfer assembly comprises a bearing member, and the bearing member is configured to support the bottom plate of the support structure.

18. The transfer assembly according to claim 17, wherein the bottom plate is provided with second positioning portions;
wherein the bearing member comprises a bearing plate, an upper surface of the bearing plate is provided with second protruding positioning portions that are matched with the second positioning portions.

19. The transfer assembly according to claim 18, wherein the second protruding positioning portions are positioning columns arranged on the upper surface of the bearing plate, the second positioning portions are second positioning notches spaced apart on a circumferential side of the bottom plate, and each of the second protruding positioning portions is matched with one of the second positioning portions.

20. The transfer assembly according to claim 17, wherein the bearing member comprises a bearing plate, and an upper surface of the bearing plate is provided with a position sensor, to detect whether the support structure is located on the bearing plate.

21. The transfer assembly according to any one of claims 17 to 20, wherein the transfer assembly further comprises a clamping base and a clamping assembly mounted on the clamping base, wherein the clamping assembly comprises:
a clamping power source, pivotally connected to the clamping base; and
a clamping member, pivotally connected to the clamping base and configured to cooperate with the bearing member to clamp the support structure, wherein the clamping member comprises a driven portion and a pressing portion fixedly connected the driven portion, the driven portion is pivotally connected to a power output end of the clamping power source, and the pressing portion is configured to compress the support structure.

22. A semiconductor processing equipment, comprising a process tube and the substrate carrier mechanism according to any one of claims 1 to 16, wherein the substrate carrier mechanism is located in the process tube.
